# NEUE EUROPÄISCHE PATENTSCHRIFT

(11) **EP 2 888 519 B2**
(45) Veröffentlichungstag und Bekanntmachung des Hinweises auf die Entscheidung über den Einspruch: **13.04.2022**
(45) Hinweis auf die Patenterteilung: 31.05.2017
(21) Anmeldenummer: 13753514.2
(22) Anmeldetag: 22.07.2013
(51) Int. Cl.: F21S 41/39, F21S 41/147, F21W 102/00, F21S 45/47, F21S 41/19

(54) **VERFAHREN ZUM POSITIONIEREN EINES LICHT FORMENDEN KÖRPERS**
METHOD FOR POSITIONING A LIGHT-SHAPING BODY
PROCÉDÉ DE POSITIONNEMENT D'UN ÉLÉMENT MODELEUR DE LUMIÈRE

(30) Priorität: 23.08.2012 AT 503362012
(43) Veröffentlichungstag der Anmeldung: 01.07.2015
(73) Patentinhaber: ZKW Group GmbH, 3250 Wieselburg (AT)
(72) Erfinder: PETSCH, Daniel, 3292 Gaming (AT)
(74) Vertreter: Patentanwaltskanzlei Matschnig & Forsthuber OG
(86) Internationale Anmeldenummer: PCT/AT2013/050138
(87) Internationale Veröffentlichungsnummer: WO 2014/028954

(56) Entgegenhaltungen:
- WO-A1-2005/027598
- WO-A2-2005/013315
- DE-A1-102004 035 747
- DE-A1-102005 003 213
- US-A1- 2007 058 904
- US-A1- 2008 291 688

## Beschreibung

Die Erfindung betrifft ein Verfahren zum Positionieren eines Licht formenden Körpers, z.B. eines Reflektors, relativ zu zumindest einer Lichtquelle.

Zur Erzeugung einer gewünschten Lichtverteilung in dem Bereich vor bzw. hinter einem Fahrzeug weist ein Lichtmodul für einen Fahrzeugscheinwerfer bzw. ein Fahrzeugscheinwerfer ein oder mehrere Lichtquellen sowie einen oder mehrere Licht formende Körper, beispielsweise einen oder mehrere Reflektoren auf. Aus der Lichtquelle austretendes Licht wird von einem solchen Reflektor als gewünschtes Lichtbild in einen Bereich vor dem Fahrzeug, in welches der Fahrzeugscheinwerfer eingebaut ist, abgestrahlt.

Um ein optimales und insbesondere gesetzeskonformes Lichtbild erzeugen zu können, kommt der exakten Positionierung der Lichtquelle in Bezug auf den Reflektor besondere Bedeutung zu. Beispielsweise dürfen bei der Verwendung von LED-Lichtquellen, welche beispielsweise eine oder mehrere Leuchtdioden als Licht emittierende Elemente aufweisen, die Abweichungen von der Sollposition nur im 1/10 mm-Bereich liegen, d.h. Reflektor und LED-Lichtquelle(n) müssen äußerst exakt zueinander positioniert werden. Die Druckschrift WO 2005/013315 A2 offenbart eine Glühbirne für Fahrzeugscheinwerfer mit einem Lampensockel, die Positionierelemente aufweist, deren Länge zur genauen Positionierung des Glühfadens angepasst wird.

Bei aktuellen Montagekonzepten wird vorerst die LED-Lichtquelle auf einen LED-Print (Leiterplatte) gelötet, dieser Print wird anschließend an einem Kühlkörper befestigt, z.B. mit diesem verklebt oder an diesem angeschraubt. Der Reflektor wird anschließend auf den Kühlkörper montiert.

Bei diesem Montagekonzept treten folgende Toleranzen auf: Toleranz in der Position der Leuchtdioden in Bezug auf das LED-Gehäuse, LED-Gehäuse in Bezug auf den LED-Print, LED-Print in Bezug auf Referenzpositionen am Kühlkörper, Kühlkörpertoleranzen an sich, Toleranz Kühlkörper - Reflektor, Reflektortoleranzen.

Mit einem solchen Montagekonzept ist entsprechend eine optimale Positionierung des Reflektors in Bezug auf die LED-Lichtquellen nicht oder nur sehr aufwändig, in entsprechend aufwändigen Anlagen möglich.

Es ist eine Aufgabe der Erfindung, ein Verfahren anzugeben, mittels welchem eine exakte und einfache Positionierung eines Reflektors bzw. eines lichtformenden Körper, wie eben eines Reflektors, einer Linse, eines Lichtleiters, einer Blende etc. in Bezug auf eine oder mehrere Lichtquellen möglich wird.

Diese Aufgabe wird mit einem Verfahren nach Anspruch 1 gelöst, welches folgende Schritte beinhaltet:
a) Anbringen der zumindest einen Lichtquelle auf einer Trägerplatte;
b) Vermessen der Position der zumindest einen Lichtquelle auf der Trägerplatte;
c) Anbringen von einer oder vorzugsweise mehreren Referenzpositionen an der Trägerplatte, wobei die Position der zumindest einen Referenzposition von der Position der zumindest einen Lichtquelle abhängt;
d) Referenzieren, d.h. Ausrichten des lichtformenden Körpers an der oder den Referenzpositionen an der Trägerplatte; und
e) Befestigen des lichtformenden Körpers in Bezug auf die Trägerplatte.

Durch das erfindungsgemäße Verfahren kann die Toleranzkette deutlich verkürzt werden, da nur noch Toleranzen bei der Vermessung des Position der Lichtquelle, Toleranzen beim Anbringen der Referenzpositionen und Toleranzen des Licht formenden Körpers an sich auftreten. Eine exakte Positionierung der Lichtquelle(n) und des Licht formenden Körpers zueinander wird dadurch drastisch vereinfacht.

Bei einer nicht erfindungsgemässen Ausführungsform sind folgende Schritte vorgesehen:
a) Anbringen von einer oder vorzugsweise mehreren Referenzpositionen an einer Trägerplatte für zumindest eine Lichtquelle;
b) Vermessen der Position der zumindest einen Referenzposition auf der Trägerplatte;
c) Anbringen der zumindest einen Lichtquelle auf der Trägerplatte unter Berücksichtigung der Position der zumindest einen Referenzposition;
d) Referenzieren, d.h. Ausrichten des lichtformenden Körpers an der oder den Referenzpositionen an der Trägerplatte; und
e) Befestigen des lichtformenden Körpers an der Trägerplatte bzw. in Bezug auf die Trägerplatte.

Bei einer konkreten Ausführungsform, bei welcher ein exaktes Positionieren des licht formenden Körpers besonders wichtig ist, ist vorgesehen, dass die zumindest eine Lichtquelle eine LED-Lichtquelle ist, welche eine oder mehrere Leuchtdioden aufweist, und dass die Trägerplatte eine Leiterplatte für die zumindest eine LED-Lichtquelle ist.

Vorzugsweise ist dabei vorgesehen, dass in Schritt a) die zumindest eine LED-Lichtquelle mit der Leiterplatte verlötet wird.

Um ein einfaches und exaktes Positionieren zu ermöglichen, ist beispielsweise vorgesehen, dass in Schritt b) die geometrische Mitte der zumindest einen Lichtquelle ermittelt wird und die Referenzpositionen in Bezug auf diese geometrische Mitte auf der Trägerplatte angeordnet werden.

Noch optimaler kann die Positionierung des licht formenden Körpers erfolgen, wenn in Schritt b) der hellste Bereich (bzw. der hellste Punkt) der zumindest einen Lichtquelle ermittelt wird und die Referenzpositionen in Bezug auf diesen hellsten Bereich auf der Trägerplatte angeordnet werden.

Bei einer konkreten Ausführungsform deserfindungsgemäßen Verfahrens ist vorgesehen, dass die Position der zumindest einen Lichtquelle mittels einer optischen Meßmethode, vorzugsweise mit einer Kamera ermittelt wird. Weiters wäre auch die Ermittlung mittels Lasertechnikdenkbar, welche noch genauer aber auch teurer ist.

Grundsätzlich sind auch mechanische Meßmethoden einsetzbar, optische Meßmethoden werden allerdings bevorzugt.

Weiters ist bei konkreten Ausführungsformen vorgesehen, dass die eine oder die mehreren Referenzpositionen in Form von einer oder mehreren Löchern, beispielsweise Langlöchern, und/oder in Form von einer oder mehreren, vorzugsweise geradlinig verlaufenden Referenzkanten ausgebildet ist/sind.

Je nach Anwendung und Ausgestaltung des licht formenden Körpers wird die geeignete Referenzfläche/Kante/Loch erstellt, die den licht formenden Körper in eine klar definierte Lage bringt. Ein Langloch dient etwa dazu, dass der licht formende Körper sich nicht mehr verdrehen lässt, während beispielsweise Kanten die Bewegung des licht formenden Körper in eine bestimmte Richtung, etwa in Richtung zu der Lichtquelle hin begrenzen.

Beispielsweise kann vorgesehen sein, dass Referenzpositionen gebohrt und/oder gefräst werden.

Die Referenzpositionen können grundsätzlich in Form von Stegen, Bohrungen, Auf- bzw. Anlageflächen, Langlöchern, Anschlägen etc. ausgebildet sein. Erfindungsgemäß ist außerdem vorgesehen, dass der lichtformende Körper mittels zumindest eines, vorzugsweise zweier Befestigungselemente in Bezug auf die Trägerplatte befestigt wird.

Für eine stabile Befestigung ist erfindungsgemäß vorgesehen, dass der lichtformende Körper mit dem zumindest einen Befestigungselement an einem Kühlkörper, an welchem die Trägerplatte befestigt ist, befestigt wird.

Dazu weist der lichtformende Körper bei einer konkreten Ausführungsform einen Befestigungssockels auf, dieser wird an dem Kühlkörper befestigt, sodass eine besondere stabile Verbindung entsteht.

Die Trägerplatte selbst ist an dem Kühlkörper befestigt, beispielsweise mit diesem verklebt, sodass ein guter Wärmeübergang von der Trägerplatte auf den Kühlkörper gewährleistet ist.

Im Folgenden ist die Erfindung an Hand der Zeichnung näher erörtert. In dieser zeigt
Fig. 1 einen prinzipiellen Aufbau zur erfindungsgemäßen Positionierung von Referenzpositionen an einer Trägerplatte,
Fig. 2 die Trägerplatte aus Figur 1 in einer Detailansicht,
Fig. 3 eine Reflektor, positioniert an einer Trägerplatte, in einer Seitenansicht,
Fig. 4 den Reflektor aus Figur 3, in einer Ansicht von der gegenüberliegenden Seite,
Fig. 5 eine Ansicht der Trägerplatte von unten mit positioniertem Reflektor,
Fig. 6 eine Ansicht auf die Trägerplatte mit angesetztem Reflektor von schräg oben, und
Fig. 7 eine Ansicht eines an einem Kühlkörper in Bezug auf die Trägerplatte befestigten Reflektors.

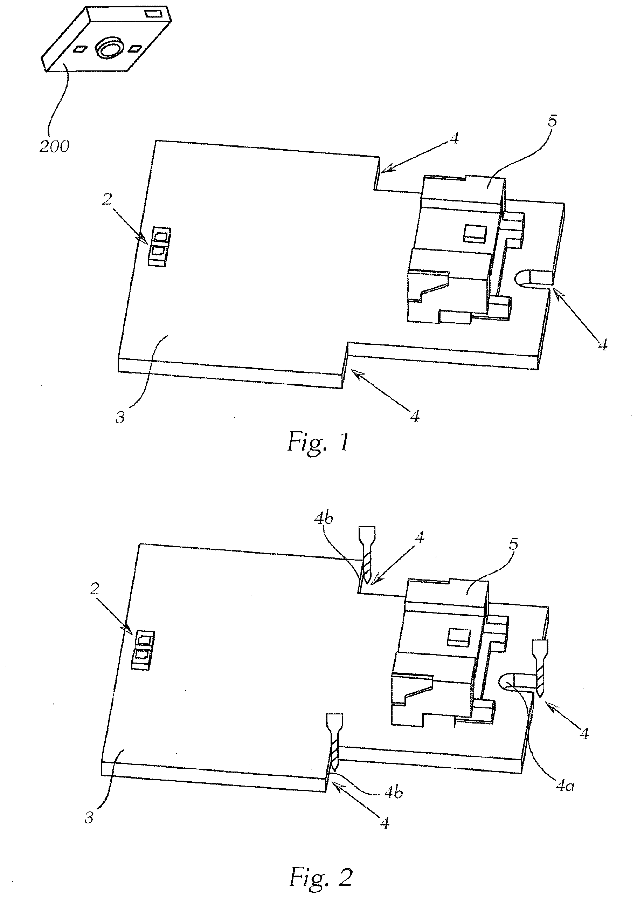

Figur 1 zeigt eine Anordnung zum Durchführen eines erfindungsgemäßen Verfahrens zum Positionieren eines Licht formenden Körpers, wie beispielsweise eines Reflektors 1, relativ zu zumindest einer Lichtquelle 2.

Figur 1 zeigt eine Trägerplatte 3, hier eine Leiterplatte (LED-Print), auf welcher in einem Schritt a) eine Lichtquelle 2 angebracht wird.

Bei der gezeigten Variante ist die Lichtquelle 2 eine LED-Lichtquelle, welche hier zwei Leuchtdioden aufweist. Entsprechend ist, wie oben schon erwähnt, die Trägerplatte 3 eine Leiterplatte für die LED-Lichtquelle 2. Vorzugsweise wird dabei in Schritt a) die LED-Lichtquelle 2 mit der Leiterplatte 3 verlötet.

Figur 1 zeigt weiters eine Kamera 200, mittels welcher in Schritt b) die Position der LED-Lichtquelle 2 auf der Trägerplatte 3 ermittelt wird.

Dabei wird in Schritt b) beispielsweise die geometrische Mitte der LED-Lichtquelle 2 ermittelt, oder es wird in Schritt b) der maßgebliche hellste Bereich (bzw. der hellste Punkt) der LED-Lichtquelle 2 ermittelt.

Umfasst dabei die LED-Lichtquelle genau eine LED, so ist für das Referenzieren bzw. Positionieren der Referenzpositionen der hellste Punkt dieser LED maßgeblich.

Umfasst die LED-Lichtquelle zwei oder mehrere LEDs, so hängt es vom jeweiligen Anwendungsfall ab, ob der relevante hellste Punkt jener ist, der von allen LEDs der LED-Lichtquelle gemeinsam erzeugtwird, oder ob etwa der hellste Punkt lediglich einer bestimmten, definierten LED (z.B. bei 3 LEDs die mittlere LED) der LED-Lichtquelle betrachtet wird. In letzterem Fall ist nur die Vermessung bzw. Ermittlung des hellsten Punktesdieser einen, ausgezeichneten LED notwendig. Es kann auch vorgesehen sein, dass ein Teilmenge aller LEDs einer LED-Lichtquelle betrachtet und deren gemeinsam erzeugter hellster Punkt ermittelt wird.

Generell wird also nach der Bestückung der LED-Platine mit der LED-Lichtquelle der für den konkreten Anwendungsfall maßgebliche hellste Punkt bzw. Bereich durch Vermessung der einen definierten, der mehreren definierten LEDs oder alles LEDs ermittelt.

Es ist auch denkbar, dass fix, etwa von Herstellerseite der Leuchtdioden bzw. der LED-Lichtquellen vorgegeben ist, welcher Punkt der hellste Punkt ist bzw. welcher Punkt als Ausgangspunkt zur Referenzierung verwendet werden soll.

In einem nächsten Schritt c) werden mehrere Referenzpositionen 4 für einen Reflektor 1 an der Trägerplatte 3 angebracht, wobei die Lage der Referenzpositionen 4 von der Position der LED-Lichtquelle 2 abhängt.

Das Anordnen der Referenzpositionen erfolgt dabei vorzugsweise unter Berücksichtigung der geometrischen Mitte der LED-Lichtquelle 2 oder des hellsten Bereiches der LED-Lichtquelle 2.

Bei den Referenzpositionen 4 handelt es sich in dem gezeigten Beispiel, wie insbesondere in Figur 2 zu erkennen ist, um ein an einer Seite offenes Langloch 4a sowie um zwei geradlinig verlaufende Referenzkanten bzw. Referenzebenen 4b. Die Referenzpositionen 4 werden beispielsweise gebohrt, gefräst oder auf andere Art und Weise gefertigt, z.B. kann auch Laserschneiden zum Einsatz kommen.

Weiters ist in Figur 2 noch ein Steckergehäuse 5 für die elektrische Kontaktierung der LED-Lichtquelle 2 gezeigt.

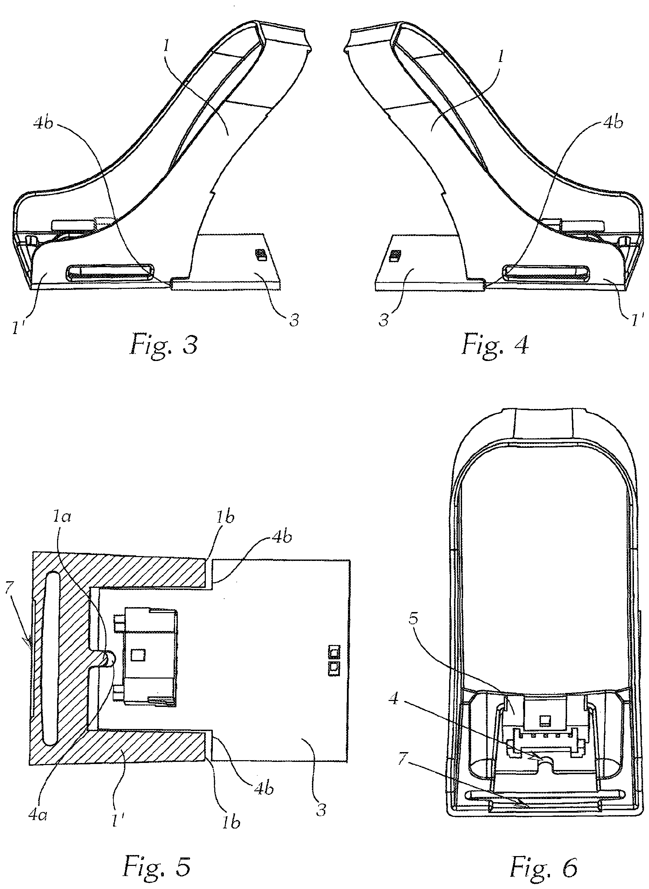

An diesen Referenzpositionen 4 wird in einem nächsten Schritt d) der Reflektor 1 referenziert, d.h. an der Trägerplatte 3 ausgerichtet und positioniert, wie dies in den Figuren 3 - 6 aus verschiedenen Ansichten dargestellt ist.

Der Reflektor 1 verfügt dabei in der gezeigten Ausführungsform über einen Befestigungssockel 1', der mit den entsprechenden, zu den Referenzpositionen 4a, 4b korrespondierenden Ausformungen, beispielsweise einem Fortsatz 1a, welcher in dem Langloch 4a angeordnet wird, sowie von Sockelflächen bzw. Sockelebenen 1b, welche zur Anlage an den Referenzflächen 4b der Trägerplatte 3 gelangen, ausgestattet ist. (Die zumindest eine reflektierende Fläche des Reflektors 1 ist in den Figuren nicht dargestellt.)

In den Figuren 3 und 4 ist die Referenzierung des Reflektors bzw. des Reflektorsockels 1' an den Referenzflächen 4b mit seinen Abschnitten 1b gut zu erkennen, während die Figuren 5 und 6 zeigen, wie der Reflektor 1 bzw. der Sockel 1' mit dem Fortsatz 1a in dem Langloch 4a positioniert ist.

Auf diese Weise ist der Reflektor 1 in der gewünschten Position in Bezug auf die auf der Trägerplatte 3 angeordnete LED-Lichtquelle 1 an der Trägerplatte 3 positioniert und wird in einem weiteren Schritt e). in Bezug auf die Trägerplatte 3 befestigt.

Durch die Referenzpositionen 4a, 4b nimmt der Reflektor 1 die gewünschte Position ein, in dieser kann erzum Befestigen beispielsweise miteinereigenen, nicht dargestellten Haltevorrichtung gehalten werden, bis er schlussendlich in dieser Position endgültig (unter Umständen aber lösbar) fixiert wird, wie dies unten an Hand einer konkreten Ausführungsform beispielhaft beschrieben ist.

Es kann aber auch vorgesehen sein, dass z.B. ein oder mehrere Rückstellelemente 7, beispielsweise in Form von einer oder mehreren Feder (etwa Druckfedern) vorgesehen sind, welche den Reflektor bzw. allgemein den licht formenden Körper solange in seiner Referenzposition halten, bis dieser fixiert wird.

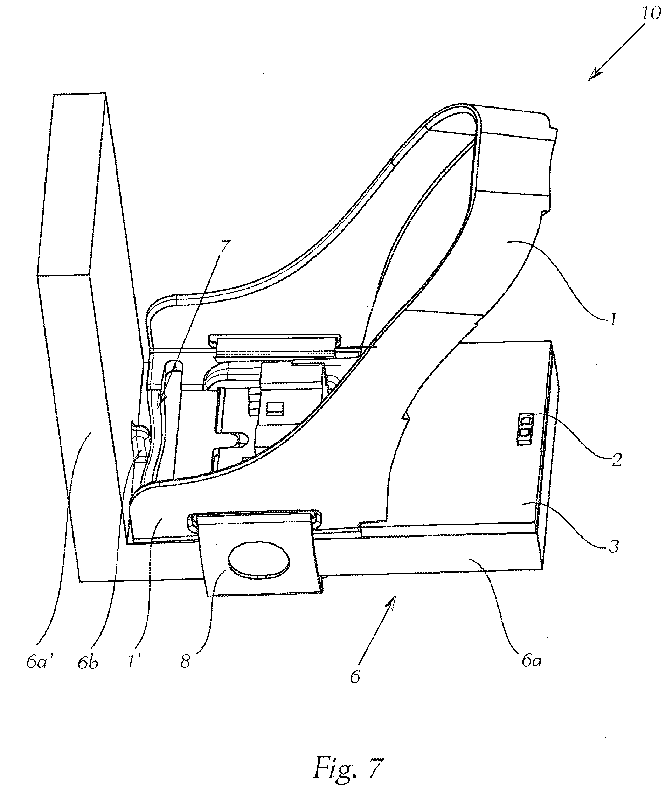

Figur 7 zeigt in diesem Zusammenhang ein erfindungsgemäßes Lichtmodul 10. Das Rückstellelement 7 ist zwischen dem Befestigungssockel 1' und einem Abschnitt 6b des Kühlkörpers 6 angeordnet und kann beispielsweise durch Positionieren des Reflektors 1 in seiner Referenzposition vorgespannt werden, sodass es den Reflektor 1 in dieser Position zumindest vorübergehend hält.

Das zumindest eine Rückstellelement 7 ist vorzugsweise, wie dargestellt, einstückig mit dem Reflektor 1, insbesondere mit dessen Befestigungssockel 1' verbunden.

Konkret weist der Kühlkörper 6 zwei Abschnitte 6a, 6a' auf, welche beispielsweise rechtwinkelig zueinander stehen. Die Trägerplatte 3 ist auf einem der beiden Abschnitte 6a angeordnet, beispielsweise mit diesem verklebt. Weiters weist der Kühlkörper 6 einen Anschlagbereich 6b für das Rückstellelement 7 auf, welcher Anschlagbereich 6b beispielsweise einstückig mit den beiden Abschnitten 6a, 6a' ausgebildet ist.

Bei einem Positionieren des Reflektors 1 liegt das Rückstellelement 7 an dem Anschlagbereich 6b an und wird zusammengedrückt, d.h. das Rückstellelement 7 ist zwischen dem Abschnitt 6b und dem Befestigungssockel 1' vorgespannt, sodass der Befestigungssockel 1' in die Referenzpositionen 4a, 4b gedrückt wird. Auf diese Weise wird der der Reflektor 1 in dieser Position zumindest vorübergehend gehalten.

Zur Befestigung des Reflektors ist beispielsweise vorgesehen, dass der Reflektor 1 mit zumindest einem, vorzugsweise wie dargestellt mit zwei Befestigungselementen 8 an einem Kühlkörper 6 (in dem gezeigten Beispiel an Abschnitt 6a des Kühlkörpers 6, an welchem die Trägerplatte 3 befestigt ist), befestigt wird. Dies ist schematisch in Figur 7 gezeigt.

Konkret wird dabei der Reflektor 1 mit seinem Befestigungssockel 1' an dem Kühlkörper 6 befestigt, sodass eine stabile Befestigung entsteht.

Die Trägerplatte 3 selbst ist an dem Kühlkörper 6 befestigt, beispielsweise mit diesem verklebt.

Vorzugsweise verfügt der Reflektor 1 bzw. sein Befestigungssockel 1' über eine Auflagefläche, mittels welcher der Sockel 1' auf der Platine aufliegt. Auf diese Weise kann der Abstand der Reflektorfläche zu der zumindest einen Lichtquelle zuverlässig eingestellt werden.

Die Befestigungselemente 8 sind beispielsweise als Feder, z.B. als Blechfeder ausgebildet, welche Federn vorzugsweise in Form von Bügelfedern ausgebildet sind. Die Federn werden auf den Kühlkörper und den Befestigungssockel bei dieser Ausführungsform vorzugsweise aufgeklipst, der Sockel 1' weistzusätzlich beispielsweise wie in Figur 7 gezeigt noch schlitzförmige Öffnungen zum Einhängen der Befestigungselemente 8 auf.

Das Lichtmodul 10 ist hier der besseren Übersichtlichkeit halber mit einem dezidierten, nur dem gezeigten Lichtmodul 10 zugeordneten Kühlkörper 6 dargestellt. In der Praxis kann aber auch vorgesehen sein, dass ein Kühlkörper für mehrere Lichtmodule vorgesehen ist, sodass also auf einem einzigen Kühlkörper mehrere Trägerplatten mit Lichtquelle und licht formendem Körper angeordnet sind.

Die Erfindung wurde obenstehend an Hand eines Reflektors erörtert, bei dem lichtformenden Körper kann es sich aber auch um eine Optik, etwa eine Linse, einen Lichtleiter etc. handeln.

## Patentansprüche

1. Verfahren zum Positionieren eines Licht formenden Körpers, z.B. eines Reflektors (1), relativ zu zumindest einer LED-Lichtquelle (2),
mit den folgenden Schritten:
a) Anbringen der zumindest einen Lichtquelle (2) auf einer Trägerplatte (3);
b) Vermessen der Position der zumindest einen Lichtquelle (2) auf der Trägerplatte (3);
c) Anbringen von einer oder vorzugsweise mehreren Referenzpositionen (4) an der Trägerplatte (3), wobei die Position der zumindest einen Referenzposition (4) von der Position der zumindest einen Lichtquelle (2) abhängt;
d) Referenzieren, d.h. Ausrichten des lichtformenden Körpers an der oder den Referenzpositionen (4) an der Trägerplatte (3); und
e) Befestigen des lichtformenden Körpers in Bezug auf die Trägerplatte (3),
wobei die eine oder die mehreren Referenzpositionen (4) in Form von einer oder mehreren Löchern, beispielsweise Langlöchern (4a), und/oder in Form von einer oder mehreren, vorzugsweise geradlinig verlaufenden Referenzkanten (4b) ausgebildet ist/sind,
**dadurch gekennzeichnet, dass**
in Schritt b)
die geometrische Mitte der zumindest einen Lichtquelle (2) ermittelt wird und die Referenzpositionen (4) in Bezug auf diese geometrische Mitte auf der Trägerplatte (3) angeordnet werden, oder
der maßgebliche hellste Bereich bzw. der hellste Punkt der zumindest einen Lichtquelle (2) ermittelt wird und die Referenzpositionen (4) in Bezug auf diesen maßgeblichen hellsten Bereich bzw. diesen hellsten Punkt auf der Trägerplatte (3) angeordnet werden, und wobei der lichtformende Körper in Bezug auf die Trägerplatte (3) befestigt wird, indem
er mittels zumindest eines, vorzugsweise zweier Befestigungselemente (8) an einem Kühlkörper (6), an welchem die Trägerplatte (3) befestigt ist, befestigt wird.

2. Verfahren nach Anspruch 1, **dadurch gekennzeichnet, dass** die zumindest eine Lichtquelle (2) eine LED-Lichtquelle ist, welche eine oder mehrere Leuchtdioden aufweist, und dass die Trägerplatte (3) eine Leiterplatte für die zumindest eine LED-Lichtquelle ist.

3. Verfahren nach Anspruch 2, **dadurch gekennzeichnet, dass** in Schritt a) die zumindest eine LED-Lichtquelle (2) mit der Leiterplatte (3) verlötet wird.

4. Verfahren nach einem der Ansprüche 1 bis 3, **dadurch gekennzeichnet, dass** die Position der zumindest einen Lichtquelle (2) bzw. der zumindest einen Referenzposition mittels einer optischen Meßmethode, vorzugsweise mit einer Kamera (200) ermittelt wird.

5. Verfahren nach einem der Ansprüche 1 bis 4, **dadurch gekennzeichnet, dass** Referenzpositionen (4) gebohrt und/oder gefräst werden.

## Claims

1. A process for positioning a light-forming body, e.g., a reflector (1), relative to at least one LED light source (2),
with the following steps:
a) Attaching the at least one light source (2) to a mounting plate (3);
b) Measuring the position of the at least one light source (2) on the mounting plate (3);
c) Putting one or preferably more reference positions (4) on the mounting plate (3), the position of the at least one reference position (4) depending on the position of the at least one light source (2);
d) Referencing, i.e., aligning the light-forming body to the reference position(s) (4) on the mounting plate (3); and
e) Fastening the light-forming body in relation to the mounting plate (3),
the one or more reference positions (4) being in the form of one or more holes, for example elongated holes (4a), and/or in the form of one or more reference edges (4b), preferably running in a straight line,
**characterized in that**
in step b)
the geometric center of the at least one light source (2) is determined and the reference positions (4) are arranged on the mounting plate (3) in relation to this geometric center, or
the significantly brightest area or the brightest point of the at least one light source (2) is determined and the reference positions (4) are arranged on the mounting plate (3) in relation to this significantly brightest area or this brightest point,
the light-forming body being fastened in relation to the mounting plate (3), by
fastening it, by means of at least one, preferably two, fastening elements (8) to a heat sink (6) to which the mounting plate (3) is fastened.

2. The process according to claim 1, **characterized in that** the at least one light source (2) is an LED light source that has one or more light-emitting diodes and **in that** the mounting plate (3) is a printed circuit board for the at least one LED light source.

3. The process according to claim 2, **characterized in that** in step a) the at least one LED light source (2) is soldered with the printed circuit board (3).

4. The process according to any one of claims 1 through 3, **characterized in that** the position of the at least one light source (2) or the at least one reference position is determined by means of an optical measurement method, preferably with a camera (200),

5. The process according to any one of claims 1 through 4, **characterized in that** reference positions (4) are drilled and/or milled.

## Revendications

1. Procédé de positionnement d'un élément modeleur de lumière, par exemple d'un réflecteur (1), par rapport à moins une source lumineuse à LED (2),
comportant les étapes suivantes :
a) mise en place de la ou des sources lumineuses (2) sur une plaque de support (3) ;
b) mesure de la position de la ou des sources lumineuses (2) sur la plaque de support (3) ;
c) mise en place d'une ou de préférence de plusieurs positions de référence (4) sur la plaque de support (3), la position de la ou des positions de référence (4) dépendant de la position de la ou des sources lumineuses (2) ;
d) référencement, c'est-à-dire alignement de l'élément modeleur de lumière sur la ou les positions de référence (4) sur la plaque de support (3) ; et
e) fixation de l'élément modeleur de lumière par rapport à la plaque de support (3),
la ou les différentes positions de référence (4) étant réalisées sous forme d'un ou de plusieurs trous, par exemple de trous oblongs (4a), et/ou sous forme d'un ou de plusieurs bords de référence (4b) s'étendant de préférence de façon rectiligne,
**caractérisé par le fait que**
dans l'étape b)
le centre géométrique de la ou des sources lumineuses (2) est déterminé et les positions de référence (4) sont disposées sur la plaque de support (3) par rapport à ce centre géométrique, ou
la zone la plus lumineuse déterminante ou le point le plus lumineux de la ou des sources lumineuses (2) est déterminé et les positions de référence (4) sont disposées sur la plaque de support (3) par rapport à cette zone la plus lumineuse déterminante ou à ce point le plus lumineux, et où
l'élément modeleur de lumière est fixé par rapport à la plaque de support (3), en ce que il est fixé au moyen d'au moins un, de préférence de deux éléments de fixation (8) sur un dissipateur thermique (6) auquel la plaque de support (3) est fixée.

2. Procédé selon la revendication 1, **caractérisé par le fait que** la au moins une source lumineuse (2) est une source lumineuse à LED, laquelle présente une ou plusieurs diodes électroluminescentes, et que la plaque de support (3) est une carte de circuit imprimé pour la au moins une source lumineuse à LED.

3. Procédé selon la revendication 2, **caractérisé par le fait que**, dans l'étape a), la au moins une source lumineuse à DEL (2) est soudée à la carte de circuit imprimé (3).

4. Procédé selon l'une des revendications 1 à 3, **caractérisé par le fait que** la position de la ou des sources lumineuses (3) ou de la ou des positions de référence est déterminée au moyen d'une méthode de mesure optique, de préférence avec une caméra (200).

5. Procédé selon l'une des revendications 1 à 4, **caractérisé par le fait que** les positions de référence (4) sont percées et/ou fraisées.
